Europäisches Patentamt

European Patent Office

Office européen des brevets

(11) Veröffentlichungsnummer: **0 157 241 B1**

# EUROPÄISCHE PATENTSCHRIFT

(45) Veröffentlichungstag der Patentschrift:
28.10.87

(21) Anmeldenummer: 85102860.5

(22) Anmeldetag: 13.03.85

(51) Int. Cl.⁴: **G 03 G 5/14,** G 03 G 5/04, G 03 G 13/26, H 05 K 5/06

(54) **Lichtempfindliches Aufzeichnungsmaterial und dessen Verwendung in einem Verfahren zum Herstellen einer druckform oder einer gedruckten Schaltung.**

(30) Priorität: 17.03.84 DE 3409888

(43) Veröffentlichungstag der Anmeldung:
09.10.85 Patentblatt 85/41

(45) Bekanntmachung des Hinweises auf die Patenterteilung:
28.10.87 Patentblatt 87/44

(84) Benannte Vertragsstaaten:
AT BE CH DE FR GB IT LI NL SE

(56) Entgegenhaltungen:
EP - A - 0 066 215
DE - A - 1 811 209
DE - A - 3 310 804
DE - B - 1 447 008

(73) Patentinhaber: HOECHST AKTIENGESELLSCHAFT,
Postfach 80 03 20, D-6230 Frankfurt am Main 80 (DE)

(72) Erfinder: Lehmann, Peter, Dr. Dipl.-Chem., An der
Ziegelei 12, D-6233 Kelkheim (DE)
Erfinder: Michel, Manfred, Dr. Dipl.-Chem.,
Bergmannweg 9, D-8706 Höchbera (DE)

## Beschreibung

Die vorliegende Erfindung betrifft ein lichtempfindliches Aufzeichnungsmaterial aus einem elektrisch leitenden, zur Herstellung einer Druckform oder einer gedruckten Schaltung geeigneten Schichtträger und einem photoleitfähigen Schichtsystem, enthaltend Photoleiter, Bindemittel, Sensibilisierungsfarbstoff und übliche Zusätze, sowie dessen Verwendung in einem Verfahren zum Herstellen einer Druckform oder einer gedruckten Schaltung.

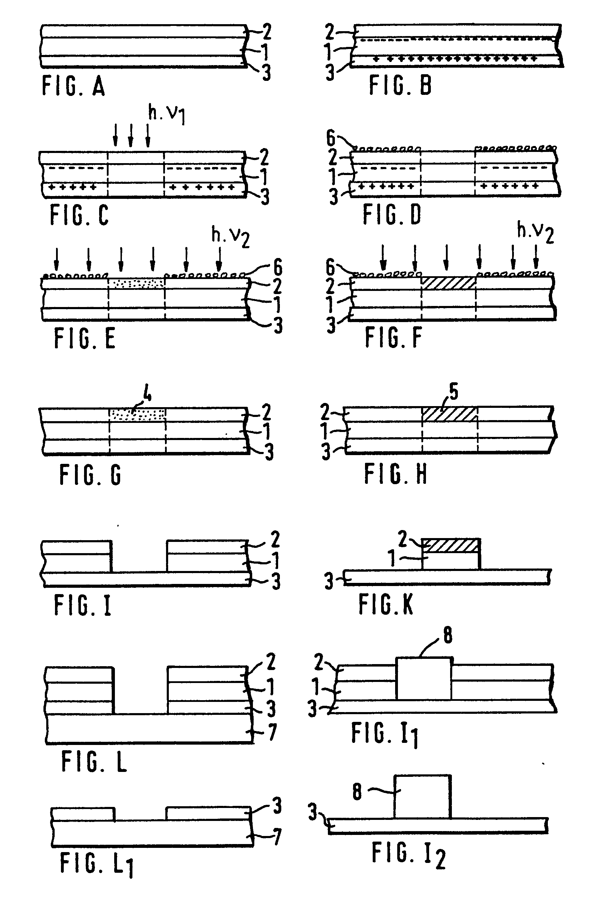

Es sind Verfahren bekannt, welche die hohe Lichtempfindlichkeit elektrophotographischer Systeme zur Bilderzeugung nutzen. Ein besonderer Vorteil ist hierbei, dass die Abbildung durch Laser- oder Projektionsbelichtung erfolgen kann. Eine Filmvorlage ist nicht erforderlich.

Die Herstellung von Flachdruckplatten auf elektrophotographischem Wege ist aus DE-PS 1 117 391, entsprechend GB-PS 944 126, bekannt. Die dabei benutzten Druckplatten sind mit einer Beschichtung versehen, welche neben einem geeigneten Bindemittel und entsprechenden Sensibilisierungsfarbstoff einen organischen Photoleiter enthält. Auf dieser Schicht wird durch elektrostatisches Aufladen und bildmässiges Belichten ein latentes Ladungsbild erzeugt, das mit einem Trocken- oder Flüssigentwickler sichtbar gemacht wird. Das erhaltene Tonerbild wird zum Beispiel durch Erhitzen der Platte fixiert, damit im abschliessenden Entschichtungsschritt die Tonerbildstellen vor dem Angriff der Entschichterlösung geschützt werden.

Ein solches Verfahren weist jedoch noch Nachteile auf. So muss der fixierte Toner entweder mit einem Lösungsmittel von der Druckplattenoberfläche abgewaschen werden, oder man muss einen erhöhten Makulaturanfall bei Druckbeginn in Kauf nehmen, wenn der Toner erst in der Druckmaschine «abläuft». Andererseits ist die erreichbare Auflösung begrenzt, da das Einbrennen des Toners zu unerwünschten Tonwertverschiebungen führt. Ferner muss die Temperatur in der Einbrennphase mit erheblichem Regelaufwand im optimalen Bereich gehalten werden. Schliesslich erreicht man auch nicht höhere Auflagen, da die druckenden Bildstellen einer mechanischen Beanspruchung auf längere Dauer nicht standhalten.

Es wurden schon Versuche unternommen, die Vorteile des beschriebenen elektrophotographischen Verfahrens mit denen konventioneller Positiv- oder Negativsysteme zu verbinden. Aus DE-PS 1 447 008, entsprechend GB-PS 996 315, ist die Herstellung einer Flachdruckplatte bekannt, die mit einem Gemisch aus organischen Photoleitern und den Bestandteilen konventionell arbeitender Positivschichten auf der Basis von o-Chinondiazid beschichtet wurde. Das elektrophotographisch auf dieser Schicht erzeugte Tonerbild wurde in einem Nachbelichtungsschritt mit aktinischem Licht als Photomaske benutzt. Die Löslichkeitsdifferenzierung zwischen Bild- und Nichtbildstellen wurde über die photochemische Reaktion des belichteten o-Chinondiazids herbeigeführt. Nachteilig hierbei ist jedoch, dass die Dunkelleitfähigkeit dieser Beschichtung hoch ist und dass die Löslichkeitsunterschiede zwischen Bild- und Nichtbildstellen wegen des relativ hohen Photoleiteranteils begrenzt sind.

Eine negativ arbeitende Photoleiterschicht ist aus DE-PS 1 811 209, entsprechend GB-PS 1 274 296, bekannt. Hier wird ein Aufzeichnungsmaterial verwendet, das in der photoleitfähigen Schicht einen zur Photopolymerisation befähigten Photoleiter aus der Gruppe der Vinyloxazole und Vinylcarbazole enthält. Nachteilig ist, dass selbst bei hohem Photoleitergehalt der Schicht die Aushärtung der nicht betonerten Bereiche trotz relativ hoher Lichtstärke noch nicht erhöhten Anforderungen genügt.

Um die Nachteile dieser Verfahren zu vermeiden, wurde auch schon versucht, eine Photoleiterschicht auf der lichtempfindlichen Schicht aufzubringen. Solche Doppelschichten sind in DE-PS 1 071 478, entsprechend US-PS 2 939 787, in EP-A 0 053 362 sowie in DE-OS 3 310 804, entsprechend GB-A 2 121 201, beschrieben. In allen Fällen wird eine Photoleiterschicht als Deckschicht auf eine konventionell positiv oder negativ arbeitende lichtempfindliche Beschichtung aufgetragen. Eine solche Verfahrensweise entspricht der elektrophotographischen Verfahrensweise, weil man dann das Tonerbild auf der Oberfläche der Photoleiterschicht erzeugen kann.

Diese Kombination der Schichten weist jedoch eine Reihe von Nachteilen auf. Einmal besteht eine erhöhte Unterstrahlungsgefahr, da die durch das Tonerbild gebildete Photoleitermaske und die lichtempfindliche Basisschicht durch die Photoleiterschicht voneinander getrennt sind. Die Photoleiterschicht muss deshalb möglichst dünn sein. Zum anderen darf die Schicht nur solche Photoleiter und Sensibilisatorfarbstoffe enthalten, die durchlässig sind für Strahlung derjenigen Wellenlängen, welche zur Photoreaktion in der lichtempfindlichen Schicht geeignet sind. Ausserdem wird bei Kombination von Photoleiterschicht und einer negativ arbeitenden Schicht die Photoleiterschicht beim Entschichten auch von den Bildstellen entfernt. Sie steht deshalb nicht mehr für die weiteren Verarbeitungsschritte zur Verfügung. Dies gilt auch bei der Kombination von Photoleiterschicht und positiv arbeitender Schicht, wenn das aufgebrachte Tonerbild nicht fixiert wird. Eine Fixierung führt jedoch andererseits zum bereits oben erwähnten unerwünschten Tonerablauf während des Druckbeginns. Schliesslich ist nachteilig, dass in Fällen, in denen Photoleiterschicht und lichtempfindliche Schicht eine nicht völlig gleichmässige Grenzfläche zueinander bilden, man nach der Entschichtung eine Schicht unterschiedlicher Dicke erhält, was zu vorzeitigem Verschleiss der hergestellten Druckform führen kann, bzw. zur ungleichmässigen Wiedergabe gerasterter Vorlagen.

Aufgabe der vorliegenden Erfindung war es daher, die beschriebenen Nachteile der bekannten Verfahren zu vermeiden und die Vorteile vom elektrophotographischer und konventionell lichtempfindlicher Beschichtung optimal zu verbinden und ein Aufzeichnungsmaterial zu schaffen, das den technisch gestellten Anforderungen an Auflagenhöhe, Lichtempfindlichkeit, Auflösung und gute Handhabbarkeit in hohem Masse gewachsen ist.

Die Lösung dieser Aufgabe geht aus von einem lichtempfindlichen Aufzeichnungsmaterial aus einem elektrisch leitenden, zur Herstellung einer Druckform oder einer gedruckten Schaltung geeigneten Schichtträger und einem photoleitfähigen Schichtsystem, enthaltend Photoleiter, Bindemittel, Sensibilisierungsfarbstoff und übliche Zusätze, und sie ist dadurch gekennzeichnet, dass das photoleitfähige System aus einer auf dem Schichtträger aufgebrachten photoleitfähigen Schicht und einer lichtempfindlichen Deckschicht, die mindestens eine photochemisch reaktive Verbindung enthält, besteht. Vorzugsweise ist in der lichtempfindlichen Deckschicht als photochemisch reaktive Verbindung eine Verbindung oder eine Kombination von Verbindungen vorhanden, deren Löslichkeit in alkalisch wässrigen und/oder alkoholischen Lösungsmittelsystemen durch aktinische Bestrahlung erniedrigt wird, wenn ein positiv arbeitendes Material erwünscht ist. Ist andererseits ein negativ arbeitendes Material beabsichtigt, so ist in der lichtempfindlichen Deckschicht als photochemisch reaktive Verbindung eine Verbindung oder eine Kombination von Verbindungen vorhanden, deren Löslichkeit in alkalisch wässrigen und/oder alkoholischen Lösungsmittelsystemen durch aktinische Bestrahlung erhöht wird.

Hierdurch wird erreicht, dass ein Aufzeichnungsmaterial zur Verfügung gestellt werden kann, das sich durch eine grosse Auflagenhöhe und hohe Lichtempflindlichkeit auszeichnet. Sein Aufbau gestattet es, dass man Bebilderung und Löslichkeitsdifferenzierung durch Bestrahlung mit aktinischem Licht in getrennten Arbeitsschritten und ohne Einsatz eines Vakuumrahmens unter jeweils optimalen Bedingungen ausführen kann. Auch die Tonwertwiedergabe bei gerasterten Vorlagen kann in Abhängigkeit von der Bestrahlungsdauer gesteuert werden. Eine unkontrollierte Unterstrahlung wird zusätzlich dadurch vermieden, dass das Tonerbild auf der lichtempfindlichen Deckschicht angeordnet ist. Eine Fixierung des als Photomaske dienenden Tonerbildes ist nicht erforderlich. Das hat zum Vorteil, dass eine Verfälschung des Tonerbildes durch das Fixieren vermieden wird, andererseits aber gute Korrigierbarkeit und leichtes Entfernen der Tonerpartikeln möglich ist. Beim Entschichten des erfindungsgemässen Materials bleibt in allen Fällen in den nicht weggelösten Bereichen die Schichtdicke voll erhalten. Im Falle, dass ein Nachhärten des entschichteten Materials durch Anwendung von Wärme erwünscht ist, wirkt diese insbesondere an der Oberfläche der Beschichtung, die ohnehin der stärksten Beanspruchung beim Druckvorgang ausgesetzt ist.

Das erfindungsgemässe Aufzeichnungsmaterial ist in schematischer Darstellung der beigefügten Figur A zu entnehmen, in der 1 die photoleitfähige Schicht, 2 die lichtempfindliche Deckschicht und 3 den elektrisch leitenden Schichtträger bezeichnen.

Die photoleitfähige Schicht 1 besteht erfindungsgemäss aus Materialien, wie sie üblicherweise für elektrophotographische Zwecke eingesetzt werden, zum Beispiel bekannt aus DE-PS 2 526 720, entsprechend US-PS 4 063 948. Sie besteht im wesentlichen aus Photoleiter, Bindemittel und Sensibilisierungsfarbstoff, die in Dispersion in einer Schicht oder auch getrennt in Ladungen erzeugender und Ladungen transportierender Schicht angeordnet sein können. Die photoleitfähige Schicht kann sowohl positiv als auch negativ aufladbar sein.

Geeignete Photoleiter sind z.B. anorganische Materialien, wie Se oder Zinkoxid, oder organische Materialien, wie Anthracen, Perylen, Tetracen, Carbazol-, Acylhydrazon-, Oxdiazol-, Pyrazolin-, Imidazol-, Benzimidazol-, Benzoxazol- und Benzthiazol-Derivate, oder organische Pigmente, wie Indigo, Phthalocyanin, Metallphthalocyanine, Perylenpigmente oder organische polymere Verbindungen, wie Poly-N-vinyl-carbazol, gegebenenfalls auch deren Mischungen.

Hochempfindliche Verbindungen, die für die Praxis besonders geeignet sind, sind metallfreie Phthalocyanine, Metallphthalocyanine, Oxdiazol-, Oxazol-, Hydrazon- und Pyrazolin-Derivate.

Die Verwendung photoleitfähiger, insbesondere organischer Substanzen in photoleitfähigen Schichten und ihre Verwendung zur Herstellung von Druckformen ist zum Beispiel aus den zum Stand der Technik genannten Schriften bekannt.

Dabei sind als Photoleiter solche besonders gut einsetzbar, die aromatische, carbocyclische oder heterocyclische Verbindungen darstellen, die durch eine oder mehrere Dialkylaminogruppen substituiert sind.

Hier sind Verbindungen, wie die erwähnten Oxdiazol-Derivate, zu nennen, die aus der DE-PS 1 058 836, entsprechend US-PS 3 189 447, hervorgehen, insbesondere das 2,5-Bis-(4'-dialkylaminophenyl)-oxdiazol-1, 3, 4. Weiterhin geeignete Photoleiter sind zum Beispiel Triphenylaminderivate, höher kondensierte aromatische Verbindungen, wie Anthracen, benzokondensierte Heterocyclen, Pyrazolin- oder Imidazolderivate. Hierher gehören auch Triazol- sowie Oxazolderivate, wie sie aus der DE-PS 1 060 260, entsprechend US-PS 3 112 197, bzw. 1 120 875, entsprechend US-PS 3 257 203, bekannt sind. Weiterhin sind vinylaromatische Polymere, wie Polyvinylanthracen, Polyacenaphthylen, Poly-N-vinylcarbazol sowie Mischpolymerisate aus diesen Verbindungen geeignet. Hierher gehören auch Polykondensate aus aromatischen Aminen und Aldehyden, wie sie aus der deutschen Auslegeschrift 1 197 325, entsprechend US-PS 3 244 517, bekannt sind. Neben diesen genannten Verbindungen, die vorwiegend p-leitenden Charakter haben, werden auch n-leitende Verbindungen eingesetzt. Diese sogenannten Elektronenakzeptoren sind z.B. aus der deutschen Patentschrift 1 127 218, entsprechend US-PS 3 287 123, bekannt.

Als Bindemittel sind hinsichtlich der Filmbildungseigenschaften und der Halftfestigkeit Natur- bzw. Kunstharze geeignet. Bei ihrer Auswahl spielen ausser den filmbildenden und elektrischen Eigenschaften sowie denen der Haftfestigkeit auf dem Schichtträger vor allem Löslichkeitseigenschaften eine besondere Rolle. Für praktische Zwecke sind solche Harzbindemittel besonders geeignet, die in wässrigen oder alkoholischen Lösungsmittelsystemen, gegebenenfalls unter Säure- oder Alkalizusatz, löslich sind. Aus physiologischen und Sicherheitsgründen scheiden aromatische oder aliphatische, leicht brennbare Lösungsmittel aus. Vorteilhafte Harzbindemittel sind hochmolekulare Substanzen, die alkalilöslich machende Gruppen tragen. Solche Gruppen sind beispielsweise Säureanhydrid-, Carboxyl-, Phenol-, Sulfosäuren-, Sulfonamid- oder Sulfonimidgruppen. Bevorzugt werden Harzbindemittel mit hohen Säurezahlen eingesetzt, da diese in alkakischwässrigalkoholischen Lösungsmittelsystemen besonders leicht löslich sind. Mischpolymerisate mit Anhydridgruppen können mit besonders gutem Erfolg verwendet werden, da durch das Fehlen freier Säuregruppen die Dunkelleitfähigkeit der photoleitfähigen Schicht gering ist trotz guter Alkalilöslichkeit

Ganz besonders geeignet sind Mischpolymerisate aus Styrol und Maleinsäureanhydrid, auch Phenolharze oder Umsetzungsprodukte von hydroxylgruppenhaltigen Polymeren mit Sulfonylisocyanaten entsprechend EP-PS 0 048 876 (entsprechend US-PS 4 387 151).

Als Sensibilisierungsfarbstoffe, die in organischen Lösungsmitteln lösliche oder dispergierbare Farbstoffe oder Pigmente darstellen, werden solche eingesetzt, die auch bisher für diesen Zweck verwendet wurden. Geeignete Sensibilisatoren sind z.B. aus der belgischen Patentschrift 558 078 oder aus DE-PS 2 526 720, entsprechend US-PS 4 063 948, bekannt. Geeignete Pigmente, wie Phthalocyanine, Azo-, Disazopigmente, Perylen-, Chinacridon-, Benzimidazol-Pigmente, sind zum Beispiel der deutschen Patentschrift 2 904 183, entsprechend GB-PS 2 014 748, zu entnehmen. Die Sensibilisierungsfarbstoffe sind üblicherweise in kleinen Mengen von etwa 0,001 bis 1%, die Pigmente fallweise bis zu 50% bezogen auf den Photoleiteranteil, vorhanden.

Die Schichtdicke der photoleitfähigen Schicht kann bis zu etwa 50 μm betragen. Sie liegt vorzugsweise im Bereich von etwa 2 bis 10 μm.

Die photoleitfähige Schicht kann übliche Zusätze wie Verlaufmittel und Weichmacher und/oder zwischen Schichtträger und photoleitfähiger Schicht Haftvermittler zur Verbesserung der Oberflächenstruktur, der Flexibilität und der Haftung enthalten.

Die lichtempfindliche Deckschicht, die mindestens eine photochemisch reaktive Verbindung enthält, wird wie folgt beschrieben.

Im Falle, dass es sich um eine Verbindung oder eine Kombination von Verbindungen handelt, deren Löslichkeit in alkalisch wässrigen und/oder alkoholischen Lösungsmittelsystemen durch aktinische Bestrahlung erhöht wird, d.h. dass eine positiv arbeitende Deckschicht gewährleistet ist, wird die lichtempfindliche Verbindung allein oder in Kombination mit einem löslichen Harz auf die photoleitfähige Schicht aufgebracht.

Als lichtempfindliche Verbindungen können beispielsweise o-Chinondiazide verwendet werden, wie sie zum Beispiel in DE-PS 1 447 008, entsprechend GB-PS 996 315, beschrieben sind.

Es ist auch möglich, durch Bestrahlung depolymerisierbare Verbindungen oder Harze einzusetzen.

Hierzu eignen sich zum Beispiel solche Zusammensetzungen, welche ein Polymerisat mit mindestens einer durch Säure spaltbaren C-O-C-Bindung und eine bei Bestrahlung eine starke Säure bildende Verbindung und gegebenenfalls ein geeignetes Bindemittel enthalten, wie in EP-A 0 082 463 beschrieben. Als säurespaltbare Verbindungen eignen sich zum Beispiel monomere oder polymere Orthocarbonsäurederivate, speziell ein -ester, monomere oder polymere Acetale, Enolether oder N-Acyliminocarbonate oder deren Mischungen. Als strahlungsempfindliche Komponente, welche vorzugsweise starke Säuren bilden bzw. abspalten, sind eine Vielzahl bekannter Verbindungen geeignet, wie zum Beispiel Diazonium-, Phosphonium-, Sulfonium-, Jodoniumsalze, o-Chinondiazidsulfochloride, Halogenverbindungen und metallorganische Halogenverbindungen.

Ein weiteres positiv einsetzbares Material enthält als lichtempfindliche Verbindung ein Copolymerisat aus Styrol und Maleinsäure(anhydrid), das ganz oder teilsweise mit o-Nitrobenzylalkohol verestert ist. Ein zusätzliches Bindemittel ist nicht unbedingt erforderlich.

Als alkalilösliche Bindemittel eignen sich die vorstehend für die photoleitfähige Schicht beschriebenen Bindemittel in einer Menge von etwa 50 bis 85 Gewichtsprozent der lichtempfindlichen Deckschicht.

Die positiv arbeitende lichtempfindliche Deckschicht wird in einer Menge von etwa 0,1 bis 50 g/m$^2$ aufgebracht, entsprechend einer Schichtdicke von etwa 0,1 bis 50 μm, vorzugsweise von etwa 1 bis etwa 25 μm.

Im Falle einer negativ arbeitenden Deckschicht sind in dieser eine Verbindung oder eine Kombination von Verbindungen enthalten, deren Löslichkeit in alkalisch wässrigen und/oder alkoholischen Lösungsmittelsystemen bei aktinischer Bestrahlung erniedrigt wird. Zusätzlich kann diese lichtempfindliche Schicht alkanilösliche Bindemittel enthalten.

Als lichtempfindliche Verbindungen eignen sich zum Beispiel Diazoniumsalz-Polykondensationsprodukte, wie sie beispielsweise durch Umsetzung von Diphenylamin-4-diazoniumsalzen mit Aldehyden, bevorzugt mit Formaldehyd, erhalten werden.

Vorteilhaft werden Mischkondensate verwendet, welche ausser Diazoniumsalzeinheiten noch andere, nicht lichtempfindliche Einheiten enthalten, welche von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Solche Kondensationsprodukte sind in der DE-OS 2 024 244, entsprechend GB-PS 1 312 925, beschrieben. Geeignete Diazoniumsalz-Polykondensationsprodukte sind auch solche, die in der DE-OS 2 739 774, entsprechend US-PS 4 186 017, beschrieben sind. Als lichtempfindliche Verbindungen sind weiter nieder- oder hochmolekulare organische Azide, insbesondere jedoch niedermolekulare aromatische Azidoverbindungen, die mindestens zwei Azidogruppen enthalten, geeignet. Beispiele für geeignete Verbindungen sind 4,4'-Diazido-stilben, 4,4'-Diazido-stilben-2,2'-disulfonsäure, 4,4'-Diazido-benzophenon, 4,4'-Diazido-diphenylmethan, u.a. Weitere Beispiele sind die in der GB-PS 790 131 genannten Azidostyrylverbindungen, die in der DE-PS 950 618, entsprechend GB-PS 765 909, genannten Azidoimidazolylverbindungen und die in der US-PS 2 848 328 genannten Diazidostilbenverbindungen.

Die erfindungsgemässen negativ arbeitenden Deckschickten enthalten im allgemeinen 5 bis 90, bevorzugt 20 bis 70 Gewichtsprozent an Diazonium- oder Azidoverbindungen und 95 bis 10, bevorzugt 80 bis 30% eines alkalilöslichen oder quellbaren Bindemittels. Als Bindemittel eignen sich zum Beispiel die für die Photoleiterschicht beschriebenen Polymerisate.

Zur Stabilisierung der lichtempfindlichen Diazoniumsalz- oder Azidoverbindungen ist es vorteilhaft, eine Verbindung mit Säurecharakter zuzusetzen. Besonders geeignete Säuren sind Phosphor- und Phosphonsäuren.

Den beschriebenen lichtempfindlichen Gemischen für die lichtempfindliche Deckschicht können ferner Zusatzstoffe, wie Weichmacher, Haftvermittler, oberflächenaktive Stoffe, Farbstoffe, Pigmente, Farbbildner und geringe Anteile anderer Harze zugesetzt werden. Hierzu gehören auch zum Beispiel kondensierte Melamin-Formaldehyd-Harze, welche eine thermische Nachhärtung erleichtern. Art und Menge dieser Zusätze sind vom vorgesehenen Anwendungsgebiet abhängig.

Dabei ist zu beachten, dass die zugefügten Stoffe weder die photoleitfähigen Eigenschaften der Anordnung beeinflussen, noch die Lichtreaktion bei der aktinischen Bestrahlung behindern.

Ferner kann die Deckschicht Farbstoffe oder Pigmente enthalten, welche die Schichtfestigkeit steigern und den Kontrast nach dem Bestrahlen erhöhen können. Geeignet sind Farbstoffe, wie sie zum Beispiel in den Patentschriften US-PS 3 218 167 und 3 884 693 aufgeführt sind. Besonders geeignet sind Viktoriareinblau FGA (C.I. Basic Blue 81), Viktoriareinblau B (C.I. 44 045), Rhodamine und Orasolblau GN.

Der Bildkontrast nach dem Bestrahlen kann durch Zusatz von Metanilgelb (C.I. 13 065) oder Phenylazodiphenylamin gesteigert werden.

Es können für die lichtempfindliche, negativ arbeitende Schicht aber auch photopolymerisierbare Zusammensetzungen verwendet werden. Derartige Zusammensetzungen enthalten in der Regel Bindemittel, eine oder mehrere additionspolymerisierbare Verbindungen und einen Photopolymerisationsinitiator.

Geeignete Bindemittel sind zum Beispiel Methylacrylat oder -methacrylat/Acryl- oder Methacrylsäure-Copolymerisate, Benzylacrylat oder -methacrylat/Acryl- oder Methacrylsäure-Copolymerisate, Benzylacrylat oder -methacrylat/Itacon-säure-Copolymerisate, Styrol/Itaconsäure-Copolymerisate, Halbester oder Halbamide von Styrol/Maleinsäureanhydrid-Copolymerisaten, Terpolymerisate aus Acryl- oder Methacrylsäure/Styrol/Alkylacrylat oder -methacrylat, und Vinylacetat/Crotonsäure-Copolymerisate.

Als additionspolymerisierbare Monomere eignen sich Verbindungen mit einer, vorteilhaft mit mehreren, ungesättigten Gruppen. Bevorzugte Beispiele sind Ethylenglykoldiacrylat und -dimethacrylat, Polyethylenglykoldiacrylat und -dimethacrylat, Trimethylolethantriacrylat und -methacrylat, Trimethylolpropantriacrylat und -methacrylat, Neopentylglykoldiacrylat und -dimethacrylat, Pentaerythrit- oder Dipentaerythrit-tri-, -tetra- oder -hexaacrilat oder -methacrylat, Epoxydiacrylat oder -methacrylat, Oligoacrylate (JP-AS 7361/77) und Acrylurethanharze oder Acrylurethanoligomere (JP-AS 41 708/73).

Geeignete Photopolymerisationsinitiatoren sind zum Beispiel vicinale Polyketaldonylverbindungen (US-PS 2 367 660), α-Carbonylverbindungen (US-PS 2 367 661 und 2 367 670), Acyloinether (US-PS 2 448 828), aromatische Acyloinverbindungen, die mit einem α-Kohlenwasserstoff substituiert sind (US-PS 2 722 512), mehrkernige Chinonverbindungen (US-PS 3 046 127 und 2 951 758), Kombinationen von Triallylimidazoldimer und p-Aminophenylketon (US-PS 3 549 367), Benzothiazolverbindungen (JP-AS 48 516/76), Benzothiazolverbindungen/Trihalogenmethyl-s-triazinverbindungen (JP-OS 74 887/79 und DE-OS 3 038 605, entsprechend US-PS 4 421 844) sowie Acridin- und Phenazinverbindungen (US-PS 3 751 259).

Zusätzlich zu den genannten Materialien verwendet man vorzugsweise Wärmepolymerisationsinhibitoren, wie sie aus DE-OS 3 310 804, entsprechend GB-A 2 121 201, bekannt sind, wie Hydrochinon, Benzochinon oder p-Methoxyphenol. In einigen Fällen können auch Farbstoffe, Pigmente oder pH-Indikatoren zur Erhöhung des Bildkontrastes zugesetzt werden.

Die Dicke der negativ arbeitenden Deckschicht kann in weiten Grenzen schwanken und Werte annehmen im Bereich von 0,1 bis 50 μm. Bei Verwendung von Diazoniumsalz-Polykondensatoren wird man im allgemeinen Dicken von etwa 0,2 bis 3 μm wählen, und bei Verwendung von photopolymerisierbaren Zusammensetzungen solche im Bereich von etwa 5 bis 50 μm.

Als lichtempfindliche Deckschicht kann auch ein Material verwendet werden, welches — je nach Verarbeitungsmethode — positiv oder megativ arbeitet. Ein solches Verfahren und entsprechendes Material werden beispielsweise in EP-A 0 082 463 beschrieben.

Das Aufbringen der photoleitfähigen Beschichtung auf den Schichtträger kann nach den bekannten Methoden durch Giessen, Tauchen oder Sprühen erfolgen.

Die lichtempfindliche Deckschicht wird vorzugsweise durch Laminieren oder Sprühen aufgetragen, um eine Beschädigung der photoleitfähigen Schicht zu vermeiden.

Das Laminieren kann mit einem handelsüblichen Laminator erfolgen. Die lichtempfindliche Schicht wird dabei zunächst auf einen Zwischenträger, zum Beispiel eine Polyesterfolie von 20 bis 50 μm Dicke, durch Giessen, Tauchen oder Sprühen aufgebracht und von diesem Zwischenträger durch Anwendung von Druck und Wärme auf die photoleitfähige Schicht übertragen. Der Zwischenträger kann nach dem Abkühlen, oder auch erst vor der Verarbeitung, leicht entfernt werden.

Erfolgt der Auftrag der lichtempfindlichen Deckschicht durch Sprühen, so müssen Lösungsmittelzusammensetzung und Beschichtungsbedingungen so gewählt werden, dass die Photoleiterschicht nicht angelöst wird und ein gleichmässiger, geschlossener Film entsteht.

Wird die Deckschicht durch Giessen aufgetragen, so erfolgt die Beschichtung als Vorhangbeschichtung, da bei Schleuderbeschichtung oder verwandten Methoden eine Durchmischung der beiden Schichten nicht auszuschliessen ist.

Als Schichtträger können sämtliche für diesen Zweck bekannten Materialien eingesetzt werden, wie z.B. Aluminium-, Zink-, Magnesium-, Chrom- oder Kupferplatten, deren Oberflächen vorbehandelt sein können; aber auch metallisierte Celluloseprodukte, wie Cellulosehydrat-, Celluloseacetat- oder Cellulosebutyratfolien. Auch oberflächlich hydrophil und elektrisch leitend gemachtes Papier oder Kunststoffolien sowie Verbundmaterialien aus Papier oder Folie und Metall sind einsetzbar. Auch Mehrmetallträgermaterial ist geeignet.

Als bevorzugtes Schichtträgermaterial für Druckformen wird mechanisch oder elektrochemisch aufgerauhtes Aluminium verwendet, das gegebenenfalls mit einer oberflächlichen Oxidschicht versehen ist und mit hydrophilierenden Substanzen, wie Polyvinylphosphonsäure, nachbehandelt wurde.

Zur Herstellung gedruckter Schaltungen werden metallisierte Kunststoffträger in Form von Folien oder Platten eingesetzt, wobei die Metallschicht durch Aufdampfen, Aufkaschieren oder durch chemische oder galvanische Abscheidung aufgebracht werden kann. Hier wird nach dem Entschichten die freigelegte Schichtträgeroberfläche geätzt oder an diesen Stellen galvanisch verstärkt.

Die Erfindung betrifft auch ein Verfahren zum Herstellen einer Druckform oder einer gedruckten Schaltung auf elektrophotographischem Wege, bei dem ein Aufzeichnungsmaterial, bestehend aus einem elektrisch leitenden Schichtträger und einem darauf befindlichen photoleitfähigen Schichtsystem elektrostatisch aufgeladen, bildmässig belichtet, das entstandene Ladungsbild mit einem feinteiligen Toner sichtbar gemacht und anschliessend die Schicht vollflächig einer aktinischen Bestrahlung und dann einer Entschichtung ausgesetzt wird. Das Verfahren ist dadurch gekennzeichnet, dass man als photoleitfähiges Schichtsystem eine Doppelschicht verwendet, die, vom Schichtträger aus gesehen, aus einer photoleitfähigen Beschichtung und einer lichtempfindlichen Deckschicht besteht, die durch aktinische Bestrahlung hinsichtlich ihrer Löslichkeit differenziert wird. Wahlweise werden die nicht von Toner bedeckten Bereiche der lichtempfindlichen Deckschicht zusammen mit den darunter befindlichen photoleitfähigen Schichtbestandteilen oder die von Toner bedeckten Bereiche der lichtempfindlichen Deckschicht zusammen mit den darunter befindlichen photoleitfähigen Schichtbestandteilen weggelöst, je nachdem, ob man eine Positiv- oder Negativ-Wiedergabe vorzunehmen beabsichtigt.

Das erfindungsgemässe Verfahren ist prinzipiell in schematischer Darstellung den beigefügten Figuren zu entnehmen.

Unter A ist das erfindungsgemässe Aufzeichnungsmaterial dargestellt, mit 1 als photoleitfähiger Schicht, 2 als lichtempfindlicher Deckschicht und 3 als Schichtträger, der hier nur als Metallplatte dargestellt ist. Er kann aber auch, wie unter L angegeben, aus zum Beispiel einer Folie oder Kunststoffplatte 7 bestehen, die mit einer elektrisch leitenden Schicht 3 versehen ist. In der photoleitfähigen Schicht 1 wird vorzugsweise ein organischer Photoleiter verwendet. Die lichtempfindliche Deckschicht enthält mindestens eine bei Bestrahlung Löslichkeit in dem betreffenden Entschichter bewirkende Verbindung oder mindestens eine bei Bestrahlung Unlöslichkeit in dem betreffenden Entschichter bewirkende Verbindung.

B gibt die zum Beispiel durch Coronaaufladung erzeugte elektrostatische Aufladung des erfindungsgemässen Aufzeichnungsmaterials wieder, die, wie gezeigt, negativ oder aber positiv sein kann. Figur C stellt schematisch die bildmässige Belichtung ($h \cdot \upsilon_1$) des aufgeladenen Materials dar, die über eine Optik durch Projektion oder direkt mittels Laserstrahlen erfolgen kann. Figur D gibt das Sichtbarmachen des entstandenen Ladungsbildes mit einem elektrostatischen Entwickler wieder. Das Sichtbarmachen kann sowohl mit einem Flüssigentwickler als auch mit einem Trockenentwickler erfolgen. Es kann mit einem entgegengesetzt geladenen Toner gearbeitet werden, wie hier gezeigt, es kann aber auch eine Umkehrentwicklung mit einem gleichsinnig der elektrostatischen Aufladung aufgeladenen Toner das Sichtbarmachen erfolgen. Das entstandene Tonerbild 6 kann nach dem erfindungsgemässen Verfahren fixiert werden, d.h. eingebrannt oder durch Lösungsmitteldämpfe befestigt werden. Es ist vorzugsweise wegen der späteren Entfernung des Tonerbildes jedoch von Vorteil, das Tonerbild nicht zu fixieren und lediglich entsprechend der vorhandenen elektrostatischen und adhäsiven Kräfte in dem entwickelten Zustand zu belassen.

Die Figuren E und F geben die Bestrahlung mit aktinischem Licht ($h \cdot \upsilon_2$) wieder. Hierzu sind zum Beispiel Metallhalogenid-Quecksilberdampflampen geeignet, welche einen hohen Spektralanteil im nahen UV-Bereich emittieren.

Die Bestrahlung kann einerseits dazu dienen, die nicht von Toner bedeckten Stellen 4 in den löslichen Zustand zu überführen oder die nicht von Toner bedeckten Stellen 5 unlöslich zu machen, wodurch unter G ein Positiv-Verfahren und unter H ein Negativ-Verfahren resultieren.

Die Figur G stellt die von Toner befreite Druckplatte nach E, Figur H die von Toner befreite Druckplatte nach F dar, die nummehr dem Entschichtungsverfahren unterworfen werden. Die Zusammensetzung geeigneter Entschichterlösungen ist aus der deutschen Patentschrift 1 117 391, entsprechend GB-PS 944 126, an sich bekannt. Als für das vorliegende Verfahren geeignete Entschichterlösungen werden Alkoholgemiche verwendet, denen Alkali in Form von Natriummetasilikat oder Ethanolamin zugesetzt werden. Vorzugsweise verwendet man zum Weglösen einen Entschichter, der eine alkalisch-wässrige, gegebenenfalls Netzmittel enthaltende Lösung darstellt. Der entfernte Toner kann gegebenenfalls wiederverwendet werden. Die Tonerentfernung und das Entschichten können, was bevorzugt ist, auch in einem Schritt erfolgen. Die nach dem Entschichtungsverfahren, d.h. nach dem Weglösen, verbleibenden Schichtbestandteile können einer thermischen Nachhärtung unterworfen werden. Es resultieren die fertigen Druckformen nach Figur I, resp. K, als Positiv- oder Negativ-Druckplatten.

In Falle, dass der Schichtträger, wie eingangs erwähnt, aus einer metallisierten Kunststoffplatte 3, 7 besteht, kann das Material nach Figur I dem Ätzen unterworfen werden, wodurch das durch das Entschichten freigelegte Metallbild entfernt wird (Figur L). Nach Ablösen (Strippen) der verbliebenen Schichtbestandteile resultiert eine gedruckte Schaltung nach Figur L₁. Man kann jedoch auch das Material nach Figur I einem galvanischen Bad aussetzen und dadurch die freigelegten Metallstellen galvanisch verstärken, unter Aufbringen einer weiteren Metallschicht 8, wie in Figur I₁ gezeigt. Nach dem Strippen erhält man eine fertige Leiterplatte I₂.

Entsprechende Verfahrenschritte, wie sie, von einem Material I ausgehend, gezeigt sind, können auch mit einem Material durchgeführt werden, wie es unter Figur K dargestellt ist.

Es ist erfindungsgemäss auch möglich, bei Verwendung eines angepassten Materials für die lichtempfindliche Deckschicht durch Einfügen weiterer Verfahrensschritte, wie Erwärmen und nochmaliges Bestrahlen, ein positiv arbeitendes Material bei Bedarf auch negativ arbeitend einzustellen.

Das erfindungsgemässe Verfahren weist folgende Vorteile auf.

Aufgrund der grossen Lichtempfindlichkeit des elektrophotographischen Doppelschichtsystems kann die bildmässige Belichtung durch Projektion der Bildvorlage oder auch direkt durch einen Laser mit beispielsweise niedriger Leistung erfolgen. Im Falle der Projektionsbelichtung können beliebig viele Druckplatten oder Schaltungsbilder von einer Vorlage hergestellt werden, ohne dass diese mit dem lichtempfindlichen Material in Kontakt kommt. Die Vorlage unterliegt somit praktisch keinem Verschleiss.

Es ist auch nicht erforderlich, das auf elektrophotographischem Wege erzeugte Tonerbild zu fixieren. Die Tonermaske kann daher auf einfache Weise korrigiert oder vor bzw. während der Entschichtung vollständig entfernt werden. Später folgende Verarbeitungsschritte werden dadurch nicht durch den anwesenden Toner gestört, insbesondere tritt das von herkömmlichen elektrophotographischen Druckplatten mit fixiertem Tonerbild bekannte Problem des «Tonerablaufs» bei Druckbeginn nicht auf.

Ein weiterer Vorteil ist, dass das Tonerbild unmittelbar auf der lichtempfindlichen Deckschicht erzeugt wird. Bei der vollflächigen Bestrahlung tritt deshalb keine unkontrollierte Unterstrahlung auf, wie dies häufig bei Vewendung von Filmvorlagen aufgrund von Lufteinschlüssen zwischen Film und lichtempfindlicher Schicht der Fall ist. Die Bestrahlung kann deshalb ohne Einsatz eines Vakuum-Kopierrahmens also selbst während des Transports der Platte erfolgen, was zu Zeitersparnis führt.

Die Anfärbung der lichtempfindlichen Deckschicht liefert unmittelbar bei Bestrahlung einen Farbumschlag, so dass bestrahlte und noch nicht bestrahlte Platten selbst dann zu unterscheiden sind, wenn das Tonerbild bereits entfernt wurde. Zudem können die Bildstellen von den Nichtbildstellen unterschieden werden.

Die Tonwertwiedergabe bei gerasterten Vorlagen kann man durch Wahl der Bestrahlungsbedingungen beeinflussen, wie das von konventionellen positiv oder negativ arbeitenden Druckplatten her bekannt ist. Der beim Offsetdruck in der Druckmaschine auftretende Tonwertzuwachs kann auf diese Weise zumindest teilweise ausgeglichen werden.

Bei der Entschichtung durch Weglösen werden nur die leichter löslichen Nichtbildbereiche entfernt, an den Bildstellen bleibt die Doppelschichtanordnung voll erhalten.

Es besteht die Möglichkeit, die nach der Entschichtung verbliebenen Schichtbereiche durch Anwendung von Wärme nachzuhärten, wodurch die Resistenz der Oberfläche gegen Chemikalien oder gegen mechanische Beanspruchung weiter erhöht werden kann.

Ein besonderer Vorteil des Verfahrens ist ferner seine vielfältige Verwendbarkeit, je nach Ausgangsmaterial und Verfahrensschritten.

So kann eine Positiv-Negativ-Umkehr zum Beispiel erreicht werden durch entsprechende Aufladung von elektrophotographischer Doppelschicht und Toner, durch Wahl einer positiv bzw. einer negativ arbeitenden Deckschicht oder sogar einer Deckschicht, die je nach Verarbeitung wahlweise positiv oder negativ arbeitet.

Da ein Fixieren des Tonerbildes nicht erforderlich ist, können Aufladung und Betonerung bei Bedarf wiederholt werden, oder es kann der gesamte Verfahrensablauf mit unterschiedlichen Bildvorlagen in mehreren Zyklen ausgeführt werden.

Die folgenden Beispiele sollen die vorliegende Erfindung näher beschreiben, ohne sie hierauf zu begrenzen.

### Beispiel 1

Auf eine elektrochemisch aufgerauhte und anodisierte Aluminiumplatte von 0,3 mm Stärke, welche gemäss DE-OS 1 621 478, entsprechend GB-PS 1 230 447, mit Polyvinylphosphonsäure nachbehandelt worden war, wurde folgende Beschichtungslösung aufgetragen:

| 50 | Gewichts-teile (Gt) | eines Copolymerisates aus Styrol und Maleinsäureanhydrid (Scripset^R 540, Monsanto), |
|---|---|---|
| 42 | Gt | 2-Vinyl-4(4'-diethylaminophenyl)-5-(2'-chlorphenyl)-oxazol, |
| 0,2 | Gt | Rhodamin FB (C.I. 45170) |
| 360 | Gt | Ethylenglykolmonomethylether |
| 550 | Gt | Tetrahydrofuran. |

Nach dem Trocknen betrug das Schichtgewicht 3,0 g/m².

Auf diese photoleitfähige Schicht wurde eine lichtempfindliche Deckschicht von 2,0 g/m² durch Sprühbeschichtung folgender Lösung aufgebracht:

| 0,8 | Gt | des Veresterungsproduktes aus 1 Mol 2, 3, 4-Trihydroxybenzophenon und 3 Mol Naphthochinon-(1, 2)-diazid-(2)-5-sulfonsäurechlorid, |
|---|---|---|

| 0,40 Gt | des Veresterungsproduktes aus 1 Mol 2, 2'-Dihydroxy-dinaphthyl-(1, 1')-methan und 2 Mol Naphthochinon-( 1,2 )-diazid-( 2 )-5-sulfonsäurechlorid, |
|---|---|
| 6,00 Gt | eines Kresol-Formaldehyd-Novolaks mit einem Erweichungspunkt von 120 bis 135°C und einem mittleren Molgewicht von 1500, |
| 0,60 Gt | Naphthochinon-( 1,2 )-diazid-( 2 )-4-sulfonsäurechlorid und |
| 0,30 Gt | Kristallviolett (C.I. 42 555) in |
| 40,00 Gt | Ethylenglykolmonomethylether und |
| 50,00 Gt | Tetrahydrofuran. |

Die so erhalten Kombination aus zwei Schichten wurde in einem handelsüblichen Automaten zur Herstellung von elektrophotographischen Druckformen mittels Coronaentladung mit einer negativen Aufladung versehen, durch Projektion bildmässig 20 Sekunden lang belichtet und das latente Ladungsbild mit einem handelsüblichen elektrophotographischen Trockenentwickler entwickelt.

Die betonerte Aluminiumplatte wurde anschliessend 1,0 Minute mit einer 5 kW-Metallhalogenidlampe bestrahlt.

Schliesslich wurde mit einem Plüschtampon eine Entschichterlösung aus Natriumsilikat, Glycerin, Wasser, Ethylenglykol und Ethanol gemäss EP-PS 0 034 317, entsprechend US-PS 4 388 391, auf die Platte aufgetragen. Diese löste die nicht betonerten Schichtbestandteile der Deckschicht zusammen mit der darunter liegenden Photoleiterschicht vollständig auf. Von den Bildstellen der Aluminiumplatte wurde zugleich der nicht fixierte Toner abgewaschen. Die darunter liegenden Schichtbestandteile blieben unversehrt.

Durch Wahl einer entsprechend längeren Bestrahlungszeit konnte die Platte, wie eine konventionelle Positivplatte, spitzer kopiert werden, was zu einer offeneren Tonwertwiedergabe führte. Die Auflagenleistung der Platte betrug 150 000, sie konnte durch thermische Nachhärtung der verbliebenen Schicht von dem Druck (5 Minuten, 220°C) auf 180 000 gesteigert werden.

### Beispiel 2

Wie in Beispiel 1 beschrieben, wurde auf einen Druckplattenträger eine Photoleiterschicht mit einem Schichtgewicht von etwa 4,5 g/m² aufgebracht.

Auf diese wurde eine lichtempfindliche Beschichtung folgender Zusammensetzung so aufgetragen, dass das Schichtgewicht nach dem Trocknen etwa 1,5 g/m² betrug:

| 97,0 Gt | eines Bindemittels, das durch Umsetzung von 11,3 Gt eines Polyvinylbutyrals mit einem Molgewicht von 70 bis 80 000 mit 5,11 Gt Propenylsulfonylisocyanat erhalten wurde (entsprechend DE-AS 2 053 363 bzw. US-PS 3 732 106), |
|---|---|

| 48,3 Gt | eines Diazoniumsalzpolykondensationsproduktes, hergestellt aus 1 Mol 3-Methoxydiphenylamin-4-diazoniumsulfat und 1 Mol 4,4'-Bismethoxydiphenylether in 85%iger Phosphorsäure und isoliert als Mesitylensulfonat, |
|---|---|
| 4,5 Gt | Phosphorsäure und |
| 3,5 Gt | Viktoriareinblau FGA (C.I. Basic Blue 81) in |
| 3500 Gt | Ethylenglykolmonomethylether und |
| 1035 Gt | Tetrahydrofuran. |

Die so erhaltene Doppelschicht wurde, wie unter Beispiel 1 beschrieben, elektrostatisch aufgeladen, belichtet, das entstandene Ladungsbild mit einem positiv gesteuerten Flüssigentwickler entwickelt und anschliessend unter einer Metallhalogenidlampe mit 5 kW Leistung 2 Minuten bestrahlt.

Zur Entfernung der betonerten Schichtbestandteile wurde eine wässrige Lösung eingesetzt mit

| 5 | Gt | Natriumoctylsulfat, |
|---|---|---|
| 2 | Gt | Natriummetasilikat-pentahydrat, |
| 1 | Gt | Trinatriumphosphat und |
| 1 | Gt | Phenoxyethanol. |

Die Behandlungszeit betrug 90 Sekunden. In dieser Zeit wurden sowohl die Tonerbestandteile als auch die darunterliegenden Schichtbestandteile vollständig abgelöst.

Die nicht betonerten Schichtbestandteile der Doppelschicht blieben vollständig erhalten und lieferten im Druck eine negative Abbildung der Belichtungsvorlage.

Da das Tonerbild gegenüber der Vorlage einen Tonwertzuwachs aufwies, wurde die bei Negativschichten zu beobachtende Tonwertzunahme zumindest teilweise kompensiert.

### Beispiel 3

Wie in Beispiel 2 beschrieben, wurde auf einem 100 μm dickem Aluminiumdruckplattenträger mit mechanisch aufgerauhter Oberfläche eine Doppelschicht aus einer Photoleiterschicht mit einem 2,5-Bis-(4'-diethylaminophenyl)-1, 3, 3-oxidazol als Photoleiter und einer negativ arbeitenden Deckschicht erzeugt. Anstelle des Umsetzungsproduktes aus Polyvinylbutyral und Propenylsulfonylisocyanat wurde als Bindemittel in der Deckschicht ein Copolymerisat aus Styrol und Maleinsäureanhydrid (Scripset R 540 Monsanto) eingesetzt. Zur Entschichtung dieser Platte wurde die in Beispiel 2 genannte Entschichterlösung verwendet.

Es resultierte eine Druckplatte, von der von Druckbeginn an einwandfreie Drucke erstellt werden konnten, wobei eine höhere Auflage erreicht wurde als mit einer konventionellen elektrophotographischen Druckplatte.

### Beispiel 4

Auf eine von Oxidschichten befreite, 35 μm starke Kupferfolie, die auf eine 1,5 mm starke Platte aus Phenoplast-Schichtstoff kaschiert war, wurde die in Beispiel 1 beschriebene Photoleiterschicht mit einem Schichtgewicht von 6 g/m² aufgebracht.

Auf einer 50 µm dicken Polyesterfolie als Zwischenträger wurde eine Beschichtungslösung gemäss EP-A 0 082 463 folgender Zusammensetzung aufgeschleudert, die dann als Trockenresistmaterial diente:

| | | |
|---|---|---|
| 40 | Gt | Methylethylketon, |
| 15 | Gt | Ethylenglykolethyletheracetat, |
| 5 | Gt | Diethylenglykolmonoethylether, |
| 28 | Gt | eines Kresolformaldehyd-Novolaks mit einem Erweichungsbereich von 105 bis 120°C nach Kapillar-Methode DIN 53 181, |
| 3,5 | Gt | Polyvinylethylether (Lutanol A 25), |
| 8,3 | Gt | des Polyacetals aus 2-Ethylbutyraldehyd und Triethylenglykol, |
| 0,2 | Gt | 2-(6-Methoxy-naphth-2-yl)-4, 6-bis-trichlormethyl-s-triazin, |
| 0,01 Gt | | Kristallviolettbase. |

Die Schichtdicke nach dem Trocknen betrug 25 µm.

Mit einem zur Verarbeitung von Trockenresistmaterial verwendeten Laminator wurde dieses Resistmaterial als lichtempfindliche Deckschicht unter Anwendung von Druck und einer Temperatur von 130°C auf die Oberfläche der Photoleiterschicht übertragen. Die als Zwischenträger dienende Polyesterfolie wurde anschliessend bei Raumtemperatur abgezogen.

Die Kupferbasis wurde geerdet und die Doppelschicht mit einer Corona negativ aufgeladen, bildmässig belichtet und mit einem handelsüblichen Trockenentwickler entwickelt und die Platte 10 Minuten bei 80°C nachbehandelt. Durch die Tonermaske hindurch wurde anschliessend vollflächig mit einer 5-kW-Metallhalogenidlampe 0,5 Minuten lang bestrahlt.

Falls eine Korrektur erforderlich ist, kann der Toner durch Abwischen entfernt und der Bestrahlungsschritt wiederholt werden.

Die Entschichtung konnte wahlweise entweder in 2 Schritten, bei zügiger Arbeitsweise, mit einer wässrigen Lösung mit 5 Gt Natriummetasilikat × 9 $H_2O$, 3 Gt Trinatriumphosphat × 12 $H_2O$ und dann mit der in Beispiel 2 beschriebenen Lösung erfolgen, oder in einem Schritt mit einer Lösung, die 6 Gt Diethylenglykolmonoethylether, 5 Gt Propanol, 0,7 Gt Natriummetasilikat, 2,5 Gt Trinatriumphosphat und 85 Gt Wasser enthielt.

In beiden Fällen wurden die nicht betonerten Schichtbestandteile der Doppelschicht vollständig abgelöst, während die Bildstellen erhalten blieben und hier nur der Toner abgewaschen wurde.

Anschliessend wurde die freigelegte Kupferschicht weggeätzt und die Ätzreserve, d.h. die vorhandenen Schichtbestandteile mit Lösungmitteln, wie Aceton oder Methylglykol, gestrippt.

Es wurde auf diese Weise eine gedruckte Schaltung mit exakter Leiterbahnbegrenzung erhalten.

### Beispiel 5

Es wurde wie in Beispiel 4 verfahren, jedoch nach dem Bestrahlen das Tonerbild durch Abwischen entfernt, die Platte 30 Minuten auf 120°C erwärmt und die auf Raumtemperatur abgekühlte Platte anschliessend unter einer Metallhalogenid-Quecksilberdampflampe nochmals bestrahlt. Daraufhin wurde entschichtet, wobei im Unterschied zu Beispiel 4 ein negatives Bild der Bildvorlage erhalten wurde. Die Herstellung einer gedruckten Schaltung wurde, wie in Beispiel 4 beschrieben, weitergeführt.

### Beispiel 6

Es wurde wie in Beispiel 4 verfahren, mit dem Unterschied, dass als lichtempflindliche Deckschicht auf die Photoleiterschicht ein negativ arbeitendes Material auflaminiert wurde.

Zu diesem Zweck wurde folgende Rezeptur auf Polyesterfolie als Zwischenträger, wie in Beispiel 4 beschrieben, aufgetragen:

| | | |
|---|---|---|
| 6,5 | Gt | eines Terpolymerisates aus n-Hexylmethacrylat, Methacrylsäure und Styrol (60:30:10 Gewichststeile) mit einem mittleren Molgewicht von 35 000 (gemäss DE-AS 2 363 806, entsprechend US-PS 3 930 865), |
| 5,0 | Gt | eines ungesättigten Polyurethans, das aus 3 Molen 2, 2, 4-Trimethylhexamethylendiisocyanat und 2 Molen Triethylenglykol (1. Reaktionsstufe) und danach 2 Molen Hydroxyethylmethacrylat (2. Raktionsstufe) synthetisiert wurde, |
| 2,8 | Gt | 4-Hydroxy-(2-ethylhexyl)-benzoat, |
| 0,2 | Gt | 9-Phenylacridin, |
| 0,1 | Gt | 3-Mercapto-propionsäure-2,4-dichloranilid und |
| 0,025 Gt | | des Farbstoffes «Disperse Red» (C.I. 179) in |
| 25 | Gt | Methylethylketon und |
| 2 | Gt | Ethanol. |

Wie in Beispiel 4 beschrieben, wurde die erhaltene Doppelschicht elektrophotographisch behandelt und entwickelt und 1 Minute mit einer 5 kW Metallhalogenidlampe bestrahlt.

Es wurde mit folgender Lösung entschichtet:

| | | |
|---|---|---|
| 4 | Gt | Natriumlaurylsulfat, |
| 1 | Gt | Natriumcarbonat, |
| 2 | Gt | Trinatriumphosphat × 12 $H_2O$, |
| 2 | Gt | Natriummetasilikat × 5 $H_2O$, |
| 1 | Gt | Phenoxyethanol, |
| 90 | Gt | Wasser. |

Es wurde ein negatives Abbild des Originals erhalten, das man als Leiterplatte einsetzen konnte.

### Patentanprüche

1. Lichtempfindliches Aufzeichnungsmaterial aus einem elektrisch leitenden, zur Herstellung von Druckformen oder gedruckten Schaltungen geeigneten Schichtträger und einem photoleitfähigen Schichtsystem, enthaltend Photoleiter, Bindemittel, Sensibilisierungsfarbstoff und übliche Zusätze, dadurch gekennzeichnet, dass das photoleitfähige System aus einer auf dem Schichtträger aufgebrachten photoleitfähigen Ein- oder Mehrfachschicht und einer lichtempfindlichen Deckschicht, die mindestens eine photochemisch reaktive Verbindung enthält, besteht.

2. Aufzeichnungsmaterial nach Anspruch 1, dadurch gekennzeichnet, dass in der lichtempfindlichen Deckschicht als photochemisch reaktive Verbindung eine Verbindung oder eine Kombination von Verbindungen vorhanden ist, deren Löslichkeit in alkalisch wässrigen und/oder alkoholischen Lösungsmittelsystemen durch aktinische Bestrahlung erniedrigt wird.

3. Aufzeichnungsmaterial nach Anspruch 1, dadurch gekennzeichnet, dass in der lichtempfindlichen Deckschicht als photochemisch reaktive Verbindung eine Verbindung oder eine Kombination von Verbindungen vorhanden ist, deren Löslichkeit in alkalisch wässrigen und/oder alkoholischen Lösungsmittelsystemen durch aktinische Bestrahlung erhöht wird.

4. Aufzeichnungsmaterial nach Ansprüchen 1 und 2, dadurch gekennzeichnet, dass als photochemisch reaktive Verbindung mindestens ein o-Chinondiazid vorhanden ist.

5. Aufzeichnungsmaterial nach Ansprüchen 1 und 3, dadurch gekennzeichnet, dass als photochemisch reaktive Verbindung mindestens ein Diazoniumsalz-Polykondensationsprodukt vorhanden ist.

6. Aufzeichnungsmaterial nach Ansprüchen 1 bis 5, dadurch gekennzeichnet, dass sich die nach einer aktinischen Bestrahlung leichter löslichen Schichtbereiche in einem alkalisch wässrigen, gegebenenfalls Netzmittel enthaltenden Lösungsmittel lösen.

7. Aufzeichnungsmaterial nach Anspruch 1, dadurch gekennzeichnet, dass die Schichtdicke der lichtempfindlichen Deckschicht im Bereich von etwa 0,1 bis etwa 50 µm liegt.

8. Aufzeichnungsmaterial nach Anspruch 7, dadurch gekennzeichnet, dass die Schichtdicke der lichtempfindlichen Deckschicht im Bereich von etwa 1 bis etwa 25 µm liegt.

9. Aufzeichnungsmaterial nach Anspruch 1, dadurch gekennzeichnet, dass die Schichtdicke der photoleitfähigen Schicht im Bereich von etwa 2 bis etwa 10 µm liegt.

10. Verfahren zum Herstellen einer Druckform oder einer gedruckten Schaltung auf elektrophotographischem Wege, bei dem ein Aufzeichnungsmaterial, bestehend aus einem elektrisch leitenden Schichtträger und einem darauf befindlichen photoleitfähigen Schichtsystem, elektrostatisch aufgeladen, bildmässig belichtet und das entstandene Ladungsbild mit feinteiligem Toner sichtbar gemacht, anschliessend vollflächig einer aktinischen Bestrahlung und dann einer Entschichtung ausgesetzt wird, dadurch gekennzeichnet, dass man als photoleitfähiges Schichtsystem eine Doppelschicht verwendet, die, vom Schichtträger aus gesehen, aus einer photoleitfähigen Beschichtung und einer lichtempfindlichen Deckschicht besteht, die durch aktinische Bestrahlung hinsichtlich ihrer Löslichkeit differenziert wird.

11. Verfahren nach Anspruch 10, dadurch gekennzeichnet, dass die nicht von Toner bedeckten Bereiche der lichtempfindlichen Deckschicht zusammen mit den darunter befindlichen photoleitfähigen Schichtbestandteilen weggelöst werden.

12. Verfahren nach Anspruch 10, dadurch gekennzeichnet, dass die von Toner bedeckten Bereiche der lichtempfindlichen Deckschicht zusammen mit den darunter befindlichen photoleitfähigen Schichtbestandteilen weggelöst werden.

13. Verfahren nach Ansprüchen 10 bis 12, dadurch gekennzeichnet, dass man zum Weglösen einen Entschichter verwendet, der eine alkalisch wässrige, gegebenenfalls Netzmittel enthaltende Lösung darstellt.

14. Verfahren nach Ansprüchen 10 bis 13, dadurch gekennzeichnet, dass man in der photoleitfähigen Schicht einen organischen Photoleiter verwendet.

15. Verfahren nach Ansprüchen 10 oder 11, dadurch gekennzeichnet, dass man in der lichtempfindlichen Deckschicht mindestens eine bei Bestrahlung Löslichkeit in dem betreffenden Entschichter bewirkende Verbindung verwendet.

16. Verfahren nach Ansprüchen 10 oder 12, dadurch gekennzeichnet, dass man in der lichtempfindlichen Schicht mindestens eine bei Bestrahlung Unlöslichkeit in dem betreffenden Entschichter bewirkende Verbindung verwendet.

17. Verfahren nach Ansprüchen 10 bis 16, dadurch gekennzeichnet, dass man die nach dem Weglösen verbleibenden Schichtbestandteile thermisch nachhärtet.

18. Verfahren nach Ansprüchen 10 bis 16, dadurch gekennzeichnet, dass man nach dem Weglösen die freigelegte Schichtträgeroberfläche ätzt oder galvanisch verstärkt und gegebenenfalls die verbleibenden Schichtbestandteile durch Ablösen (Strippen) entfernt.

**Claims**

1. A light-sensitive recording material composed of an electrically conductive support suitable for the production of printing forms or printed circuits, and a photoconductive layer system containing a photoconductor, binder, sensitizing dye and conventional additives, wherein the photoconductive system comprises a photoconductive single layer or multiple layer applied to the support and a light-sensitive covering layer which contains at least one photochemically reactive compound.

2. The recording material as claimed in claim 1, wherein the photochemically reactive compound present in the light-sensitive covering layer is a compound or a combination of compounds, the solubility of which in alkaline aqueous and/or alcoholic solvent systems is reduced by actinic irradiation.

3. The recording material as claimed in claim 1, wherein the photochemically reactive compound present in the light-sensitive covering layer is a compound or a combination of compounds, the solubility of which in alkaline aqueous and/or alcoholic solvent systems is increased by actinic irradiation.

4. The recording material as claimed in claims 1 and 2, wherein at least one o-quinone-diazide is present as the photochemically reactive compound.

5. The recording material as claimed in claims 1 and 3, wherein at least one diazonium salt polycondensation product is present as the photochemically reactive compound.

6. The recording material as claimed in claims 1 to 5, wherein the layer areas which are more readily soluble after actinic irradiation are dissolved in an alkaline aqueous solvent which may contain a wetting agent.

7. The recording material as claimed in claim 1, wherein the layer thickness of the light-sensitive covering layer is within the range from about 0.1 to about 50 μm.

8. The recording material as claimed in claim 7, wherein the layer thickness of the light-sensitive covering layer is within the range from about 1 to about 25 μm.

9. The recording material as claimed in claim 1, wherein the layer thickness of the photoconductive layer is within the range from about 2 to about 10 μm.

10. A process for the production of a printing form or printed circuit by electrophotographic means, in which a recording material composed of an electrically conductive support and a photoconductive layer system located thereon is electrostatically charged and exposed imagewise, and the resulting charge image is rendered visible by means of a finely particulate toner and subsequently the whole area is subjected to actinic irradiation and then to decoating, which comprises using, as the photoconductive layer system, a double layer which, as viewed from the support, is composed of a photoconductive coating and a light-sensitive covering layer which is differentiated by actinic radiation with respect to its solubility.

11. The process as claimed in claim 10, wherein those areas of the light-sensitive covering layer which are not covered by toner are dissolved away together with the photoconductive layer constituents located below.

12. The process as claimed in claim 10 wherein those areas of the light-sensitive covering layer which are covered by toner are dissolved away together with the photoconductive layer constituents located below.

13. The process as claimed in claims 10 to 12, wherein the decoating agent used for dissolving away is an alkaline aqueous solution which may contain a wetting agent.

14. The process as claimed in claims 10 to 13, wherein an organic photoconductor is used in the photoconductive layer.

15. The process as claimed in claim 10 or 11, wherein at least one compound which confers solubility in the particular decoating agent on irradiation is used in the light-sensitive covering layer.

16. The process as claimed in claim 10 or 12 wherein at least one compound which confers insolubility in the particular decoating agent on irradiation is used in the light-sensitive layer.

17. The process as claimed in claims 10 to 16, wherein the layer constituents remaining after the dissolving-away are subjected to final thermal hardening.

18. The process as claimed in claims 10 to 16, wherein, after dissolving away, the exposed support surface is etched or strengthened by electroplating and, if appropriate, the remaining layer constituents are removed by detaching (stripping).

## Revendications

1. Matériau de reprographie photosensible composé d'un support de couches conducteur de l'électricité, approprié pour la production de formes d'impression et de circuits imprimés, et d'un système de couches photoconducteur contenant photoconducteur, liant, colorant sensibilisateur et additifs usuels, caractérisé en ce que le système photoconducteur est constitué d'une couche photoconductrice simple ou multiple appliquée sur le support de couches, et d'une couche de recouvrement photosensible qui contient au moins un composé photochimiquement réactif.

2. Matériau de reprographie selon la revendication 1, caractérisé en ce que la couche de recouvrement photosensible contient, en tant que composé photochimiquement réactif, un composé ou une combinaison de composés dont la solubilité dans des systèmes de solvants alcalins aqueux et/ou alcooliques est diminuée par irradiation actinique.

3. Matériau de reprographie selon la revendication 1, caractérisé en ce que la couche de recouvrement photosensible contient, en tant que composé photochimiquement réactif, un composé ou une combinaison de composés dont la solubilité dans des systèmes de solvants alcalins aqueux et/ou alcooliques est augmentée par irradiation actinique.

4. Matériau de reprographie selon les revendications 1 et 2, caractérisé en ce que au moins un o-quinonediazide est présent en tant que composé photochimiquement réactif.

5. Matériau de reprographie selon les revendications 1 et 3, caractérisé en ce que au moins un produit de polycondensation de sel de diazonium est présent en tant que composé photochimiquement réactif.

6. Matériau de reprographie selon les revendications 1 à 5, caractérisé en ce que les zones de la couche plus facilement solubles après une irradiation actinique se dissolvent dans un solvant aqueux alcalin, contenant éventuellement un agent mouillant.

7. Matériau de reprographie selon la revendication 1, caractérisé en ce que l'épaisseur de couche de la couche de recouvrement photosensible est dans la plage allant d'environ 0,1 à environ 50 μm.

8. Matériau de reprographie selon la revendication 7, caractérisé en ce que l'épaisseur de couche de la couche de recouvrement photosensible est dans la plage allant d'environ 1 à environ 25 μm.

9. Matériau de reprographie selon la revendication 1, caractérisé en ce que l'épaisseur de couche de la couche photoconductrice est dans la plage allant d'environ 2 à environ 10 μm.

10. Procédé pour la production d'une forme d'impression ou d'un circuit imprimé, par un processus électrophotographique, dans lequel un matériau de reprographie, composé d'un support de couches conducteur de lélectricité et d'un système de couches photoconducteur se trouvant sur celui-ci, est chargé électrostatiquement, exposé selon l'image, et l'image de charge résultante est rendue visible au moyen d'un toner finement divisé, on le soumet ensuite à une irradiation actinique sur toute sa surface, puis à un enlèvement de couche, caractérisé en ce que l'on utilise en tant que système de couches photoconducteur une double couche composée, à partir du support de couches, d'un revêtement photoconducteur et d'une couche de recouvrement photosensible qui est différenciée, en ce qui concerne sa solubilité, par irradiation actinique.

11. Procédé selon la revendication 10, caractérisé en ce que les zones de la couche de recouvrement photosensible non couvertes de toner sont éliminées par dissolution, conjointement avec les constituants sous-jacents de la couche photoconductrice.

12. Procédé selon la revendication 10, caractérisé en ce que les zones de la couche de recouvrement photosensible couvertes de toner sont éliminées par dissolution, conjointement avec les constituants sous-jacents de la couche photoconductrice.

13. Procédé selon les revendications 10 à 12, caractérisé en ce que l'on utilise pour l'élimination un produit d'enlèvement de couche qui consiste en une solution aqueuse alcaline, contenant éventuellement un agent mouillant.

14. Procédé selon les revendications 10 à 13, caractérisé en ce que l'on utilise dans la couche photoconductrice un photoconducteur organique.

15. Procédé selon la revendication 10 ou 11, caractérisé en ce que l'on utilise dans la couche de recouvrement photosensible au moins un composé conférant lors d'irradiation une sulubilité dans le produit d'enlèvement de couche concerné.

16. Procédé selon la revendication 10 ou 12, caractérisé en ce que l'on utilise dans la couche photosensible au moins un composé conférant lors d'irradiation une insolubilité dans le produit d'enlèvement de couche concerné.

17. Procédé selon les revendications 10 à 16, caractérisé en ce que l'on effectue un durcissement complémentaire thermique des constituants de couche restant après l'enlèvement par dissolution.

18. Procédé selon les revendications 10 à 16, caractérisé en ce que l'on attaque ou renforce par galvanoplastie les surfaces du support de couches, mises à nu après l'enlèvement par dissolution, et on élimine éventuellement par enlèvement les constituants de couche restants.

FIG. A

FIG. B

h.$\nu_1$

FIG. C

FIG. D

h.$\nu_2$

FIG. E

h.$\nu_2$

FIG. F

FIG. G

FIG. H

FIG. I

FIG. K

FIG. L

FIG. $I_1$

FIG. $L_1$

FIG. $I_2$